(19) Europäisches Patentamt / European Patent Office / Office européen des brevets

(11) **EP 2 523 221 A1**

(12) **EUROPEAN PATENT APPLICATION**
published in accordance with Art. 153(4) EPC

(43) Date of publication:
**14.11.2012 Bulletin 2012/46**

(51) Int Cl.:
***H01L 31/04*** (2006.01)

(21) Application number: **10842207.2**

(22) Date of filing: **22.12.2010**

(86) International application number:
**PCT/JP2010/073214**

(87) International publication number:
**WO 2011/083694 (14.07.2011 Gazette 2011/28)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.01.2010 JP 2010002350**

(71) Applicants:
- **Sharp Kabushiki Kaisha**
  **Osaka-shi, Osaka 545-8522 (JP)**
- **Kyoto University**
  **Kyoto-shi, Kyoto 606-8501 (JP)**

(72) Inventors:
- **SHIGETA, Hiroaki**
  **Osaka 545-8522 (JP)**

- **YASHIRO, Yuhji**
  **Osaka 545-8522 (JP)**
- **TSUDA, Yuhsuke**
  **Osaka 545-8522 (JP)**
- **NODA, Susumu**
  **Kyoto 615-8510 (JP)**
- **FUJITA, Masayuki**
  **Kyoto 615-8510 (JP)**
- **TANAKA, Yoshinori**
  **Kyoto 615-8510 (JP)**

(74) Representative: **Müller - Hoffmann & Partner Patentanwälte**
**Innere Wiener Strasse 17**
**81667 München (DE)**

(54) **PHOTOELECTRIC TRANSDUCER**

(57) A photoelectric conversion element (1) of the present invention includes: a photoelectric conversion layer (2); and a photonic crystal provided inside the photoelectric conversion layer (2) to provide a photonic band gap, the photonic crystal being designed such that nanorods (30) whose refraction index is smaller than that of a medium of the photoelectric conversion layer (2) are provided periodically inside the photoelectric conversion layer (2), and there are provided defects (31) to provide a defect level in the photonic band gap, when a wavelength of a resonance peak corresponding to the defect level is λ, the nanorods (30) are provided two-dimensionally with a pitch of not less than λ/7 and not more than λ/2, and a coefficient $\kappa_v$ indicative of strength of coupling between the photonic crystal and the outside is substantially equal to a coefficient a of absorption of light by the photoelectric conversion layer (2).

FIG. 1

## Description

Technical Field

The present invention relates to a photoelectric conversion element having a photonic crystal structure.

Background Art

At present, for example, solar cells or optical sensors generally employ photoelectric conversion elements that convert incident light to an electric signal by photoelectric conversion. The photoelectric conversion element employs a semiconductor, and when electromagnetic waves (light) whose energy exceeds the band gap of the semiconductor are incident to the photoelectric conversion element, electrons are excited in the semiconductor from a valence band to a conduction band, so that photoelectric conversion occurs.

For example, it is generally known that a-Si which is an amorphous semiconductor has absorption at approximately 700 nm in wavelength (absorption edge of light is at approximately 700 nm). That is, electromagnetic waves (light) whose wavelength is shorter than the absorption edge are absorbed by a photovoltaic material, so that photoelectric conversion occurs in the photovoltaic material. However, an actual device exhibits absorption up to approximately 820 nm due to improvement in processing methods and manufacturing methods. Accordingly, generation of a photovoltaic power can be expected also in a band approximately between 700 nm and 820 nm in wavelength.

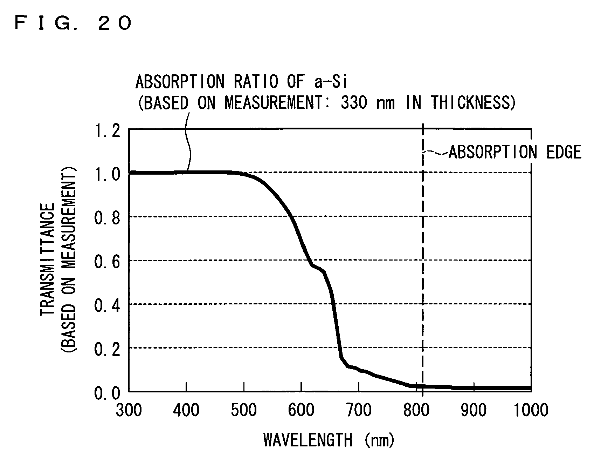

Fig. 20 is a view showing measured values of an absorption ratio of a-Si (of 330 nm in thickness) with respect to the wavelength of light.

As shown in Fig. 20, a-Si exhibits peaks of absorption at approximately 520 nm or less in wavelength, and as the wavelength becomes larger from approximately 520 nm to 820 nm at the absorption edge, a-Si exhibits a smaller absorption ratio. This is because the interaction between light and electrons is weak at a region between the absorption edge and the absorption peak of the semiconductor, and so electromagnetic waves (light) at the region are more likely to be transmitted by a-Si. Consequently, a photoelectric conversion ratio drops between the absorption edge and the absorption peak of the semiconductor. Therefore, in order that the semiconductor sufficiently absorbs light between the absorption edge and the absorption peak, it is necessary to make the semiconductor thicker.

Recently, in order to enhance a light absorption ratio, there have been developed photoelectric conversion elements using photonic crystals as disclosed in Patent Literatures 1-4 below.

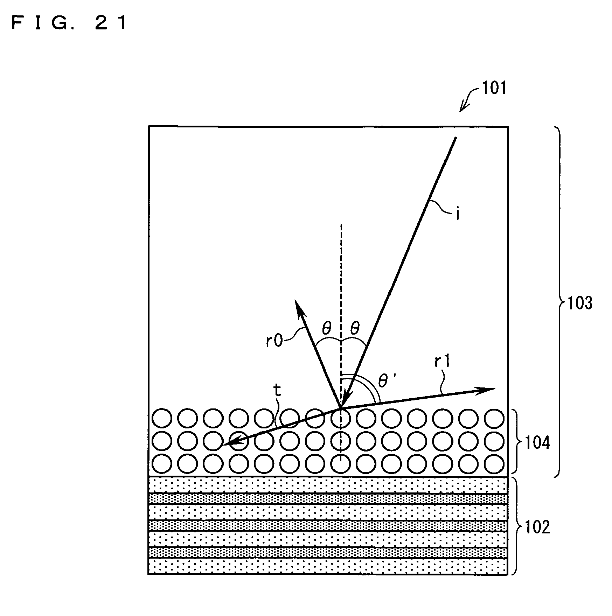

Fig. 21 is a view schematically showing a configuration of a solar cell disclosed in Patent Literature 1.

Photonic crystals are periodic structures with different dielectric constants which are artificially formed in a dielectric material with periodicity substantially equal to the wavelength of light.

As shown in Fig. 21, a solar cell 101 is designed such that photovoltaic material 103 is laminated on a distributed Bragg reflector (DBR) 102 and a photonic crystal structure 104 having a plurality of air holes is formed in the photovoltaic material 103.

A part of incident light i having entered the photovoltaic material 103 is regularly reflected by the photonic crystal structure 104 to be reflective light r0, another part of the incident light i is diffracted by the photonic crystal structure 104 to be diffractive light r1, and still another part of the incident light i is refracted by the photonic crystal structure 104 to be refractive light t.

Since the diffractive light r1 results from diffraction with an angle θ' larger than the incident angle θ, the diffractive light r1 contributes to lengthening a light path inside the photovoltaic material 103. Furthermore, total internal reflection occurs at the interface between the photovoltaic material 103 and the outside air, so that the diffractive light r1 is resonated inside the photovoltaic material 103. Consequently, the photovoltaic material 103 exhibits an improved light absorption ratio.

Furthermore, the refractive light t and light reflected by the distributed Bragg reflector 102 to return to the photonic crystal structure 104 are reflected and go back and forth to cause resonance inside the photonic crystal structure 104 and absorbed therein gradually. This also improves the light absorption ratio.

As described above, in the solar cell 101, the incident light is resonated inside the photovoltaic material 103 and the photonic crystal structure 104 so that the light is absorbed, thereby improving the absorption ratio of the photovoltaic cell. In particular, by providing a resonance wavelength at a long wavelength side where the absorption ratio of incident light is small, it is possible to realize an absorbing body capable of absorbing sunlight with a wide wavelength range.

Citation List

Patent Literatures

Patent Literature 1
Japanese Translation of PCT International Application No. 2009-533875 (published on September 17, 2009)
Patent Literature 2
Japanese Patent Application Publication No. 2006-24495 (published on January 26, 2006)
Patent Literature 3
Japanese Patent Application Publication No. 2006-32787 (published on February 2, 2006)
Patent Literature 4
International Publication WO 2007/108212 (published on September 27, 2007)

Non-patent Literatures

Non-patent Literature 1
C.Manolatou, M.J.Khan, Shanhui Fan, Pierre R.Villeneuve, H.A.Haus, Life Fellow, IEEE, and J.D.Joannopoulos "Coupling of Modes Analysis of Resonant Channel Add-Drop Filters"/IEEE JOUNAL OF QUANTUM ELECTRONICS/ SEPTEMBER 1999 VOL.35, NO.9, PP.1322-1331
Non-patent Literature 2
J.R.Tumbleston, Doo-Hyun Ko, Edward T.Samulski, and Rene Lopez "Absorption and quasiguided mode analysis of organic solar cells with photonic crystal photoactive layers"/OPTICS EXPRESS/Optical Society of America/ April 27, 2009 Vol.17,No.9 PP.7670-7681

Summary of Invention

Technical Problem

However, the solar cell 101 disclosed in Patent Literature 1 has a problem below. Since Patent Literature 1 does not describe details on the effect yielded by photonic crystals, it is unclear whether a Q value which is the result of resonance (alternatively, later-mentioned coefficients $\kappa$, $\alpha$ etc. indicative of easiness in coupling) becomes larger or smaller as the result of photonic crystal when conditions such as a thickness are changed.

That is, photonic crystals have an effect that (1) a larger Q value eliminates the interaction between light and a target device, so that light is less likely to be absorbed by the target device. Therefore, limitless increase in the Q value does not contribute to absorption of light.

Furthermore, the inventors of the present invention have discussed the mode coupling theory of photonic crystals described in Non-patent Literature 1, and newly found that (2) when easiness $\kappa_V$ in coupling of the photonic crystal structure with an outside (Qv in the case of resonator) is substantially equal to easiness $\alpha$ in absorption which is an intrinsic characteristic of a photovoltaic device ($Q_\alpha$ in the case of resonator), the maximum absorption effect is yielded.

Accordingly, in consideration of the above (1) and (2), Patent Literature 1 has a problem that what condition for designing photonic crystals allows more efficient absorption is not disclosed clearly. That is, the disclosure of Patent Literature 1 does not enable a person skilled in the art to obtain findings for sufficiently exerting the effect of improving absorption yielded by photonic crystals.

The present invention was made in view of the foregoing problems. An object of the present invention is to increase a light absorption ratio of a photoelectric conversion element having a photonic crystal structure.

Solution to Problem

In order to solve the foregoing problem, a photoelectric conversion element of the present invention includes:

(1) a photoelectric conversion layer; and
(2) a photonic crystal provided inside the photoelectric conversion layer in such a manner as to have a photonic band gap, the photonic crystal being designed such that columnar mediums whose refraction index is smaller than that of a medium of the photoelectric conversion layer are provided periodically inside the medium of the photoelectric conversion layer, and there are provided defects where the columnar mediums are not provided in order to provide a defect level in the photonic band gap,

(3) when a wavelength of a resonance peak corresponding to the defect level is $\lambda$, the columnar mediums are provided two-dimensionally with a pitch of not less than $\lambda/7$ and not more than $\lambda/2$ with respect to the wavelength $\lambda$, and

(4) a relation $0.2\,Q_V \leq Q_\alpha \leq 5.4\,Q_V$ being met, wherein $Q_V$ is a Q value representing a magnitude of a resonance effect yielded by coupling between the photonic crystal and an outside and is proportional to an inverse number of a coefficient $\kappa_V$ indicative of strength of coupling between the photonic crystal and the outside, and $Q_\alpha$ is a Q value representing a magnitude of a resonance effect yielded by the medium of the photoelectric conversion layer and is proportional to an inverse number of a coefficient of absorption of light by the medium of the photoelectric conversion layer.

With the arrangement, the photonic crystal having defects so as to provide a defect level in a photonic band gap is provided in the photoelectric conversion layer, so that light with a specific wavelength corresponding to the defect level out of light entering the photoelectric conversion layer is confined inside and around the defects in the photonic crystal and is resonated.

The photonic crystal has a periodic structure made of the medium of the photoelectric conversion layer (first medium) and a second medium (columnar mediums) whose dielectric constant (refractive index) is different from that of the first medium, and the defects are regions where the second medium lacks and is replaced with the first medium. Accordingly, the light confined and resonated in the defects goes back and forth inside the medium of the photoelectric conversion layer in and in the vicinity of the defects and is absorbed by the medium of the photoelectric conversion layer, so that the light is converted photoelectrically.

Here, in a case where the coefficient $\kappa_V$ is substantially equal to the absorption coefficient, in other words, in a case where $Q_V$ is substantially equal to $Q_\alpha$, absorption of light by the medium of the photoelectric conversion layer is at maximum.

Even in a case where $Q_V$ is not substantially equal to $Q_\alpha$, when the relation $0.2\,Q_V \leq Q_\alpha \leq 5.4\,Q_V$ is met, the effect of light absorption by the photonic crystal is enhanced.

Therefore, the above arrangement allows increasing the light absorption ratio of the photoelectric conversion element having a photonic crystal structure, and consequently allows increasing a photovoltaic power at the aforementioned band approximately between 520 nm to 820 nm in wavelength. Furthermore, by matching the wavelength of a resonance peak corresponding to the defect level with a wavelength band at which the ratio of absorption by the medium of the photoelectric conversion layer is low, the photoelectric conversion element can absorb light at a wider wavelength band.

It should be noted that a combination of configurations recited in individual claims is not limited to a combination of one claim with a claim depending from the claim. Any combination of configurations is possible between one claim and another claim that is not dependent from the claim provided that the object of the present invention can be achieved by the combination.

Advantageous Effects of Invention

As described above, the photoelectric conversion element of the present invention includes: a photoelectric conversion layer; and a photonic crystal provided inside the photoelectric conversion layer in such a manner as to have a photonic band gap, the photonic crystal being designed such that columnar mediums whose refraction index is smaller than that of a medium of the photoelectric conversion layer are provided periodically inside the medium of the photoelectric conversion layer, and there are provided defects where the columnar mediums are not provided in order to provide a defect level in the photonic band gap, when a wavelength of a resonance peak corresponding to the defect level is $\lambda$, the columnar mediums are provided two-dimensionally with a pitch of not less than $\lambda/7$ and not more than $\lambda/2$ with respect to the wavelength $\lambda$, and a relation $0.2\,Q_V \leq Q_\alpha \leq 5.4\,Q_V$ being met, wherein $Q_V$ is a Q value representing a magnitude of a resonance effect yielded by coupling between the photonic crystal and an outside and is proportional to an inverse number of a coefficient $\kappa_V$ indicative of strength of coupling between the photonic crystal and the outside, and $Q_\alpha$ is a Q value representing a magnitude of a resonance effect yielded by the medium of the photoelectric conversion layer and is proportional to an inverse number of a coefficient of absorption of light by the medium of the photoelectric conversion layer.

Consequently, light incident to the photoelectric conversion layer is confined and resonated in the defects, and light absorption by the medium of the photoelectric conversion layer is increased. Accordingly, the present invention can increase the light absorption ratio of the photoelectric conversion element having a photonic crystal structure.

Brief Description of Drawings

Fig. 1

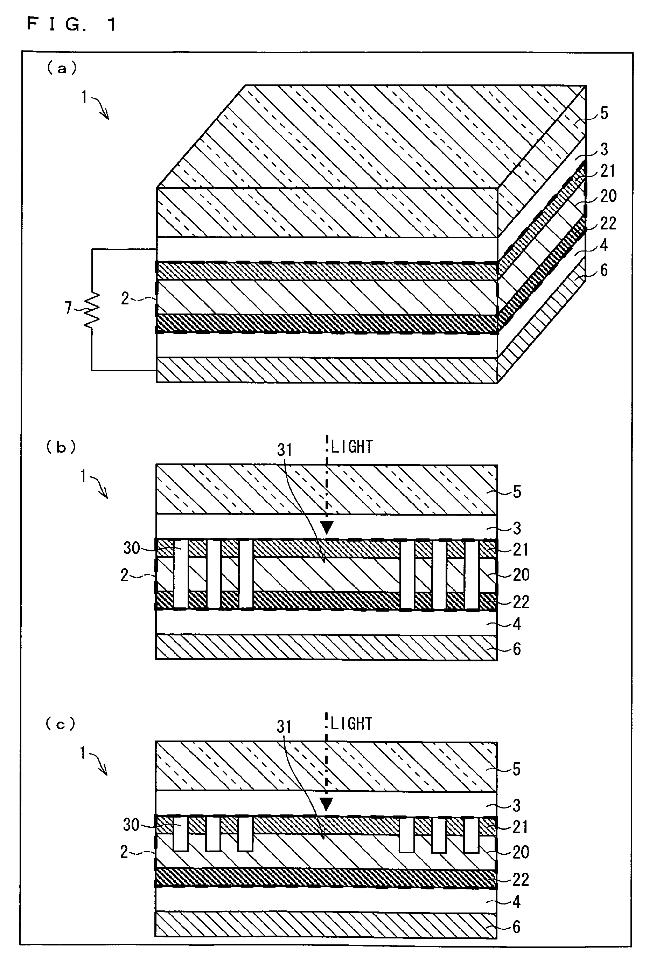

Fig. 1 is a view schematically showing a whole configuration of a photoelectric conversion element in accordance with one embodiment of the present invention.
Fig. 2

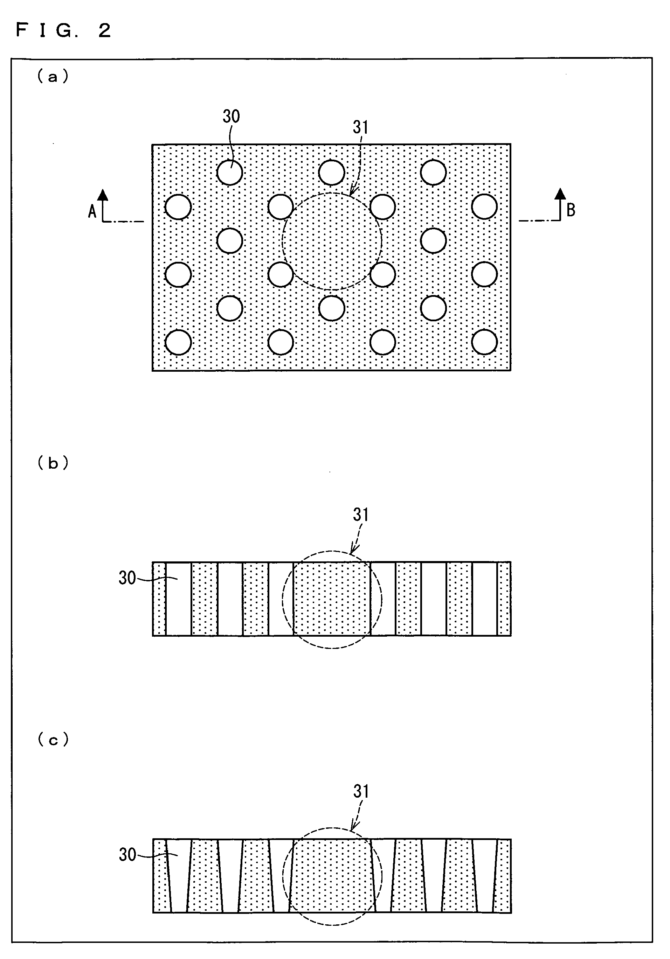

Fig. 2 is a view showing a configuration of a photonic crystal. (a) of Fig. 2 shows a top view, and (b) and (c) of Fig. 2 show cross sections taken along a line A-B of (a).
Fig. 3

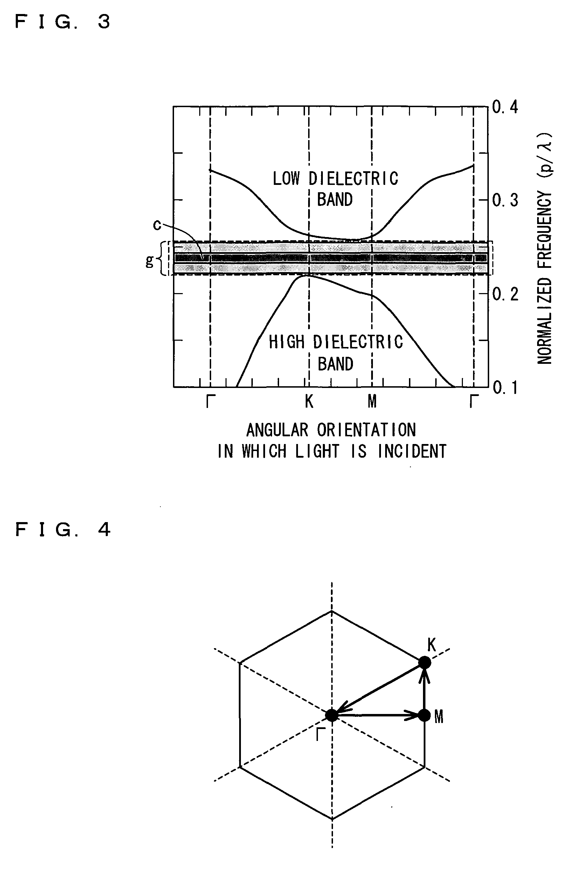

Fig. 3 is a graph showing a photonic band structure in terms of a relation between a direction in which light is incident to a photonic crystal and normalized frequency.
Fig. 4
Fig. 4 is an explanatory view showing the position of a photonic crystal having triangular lattices in a reciprocal lattice space.
Fig. 5

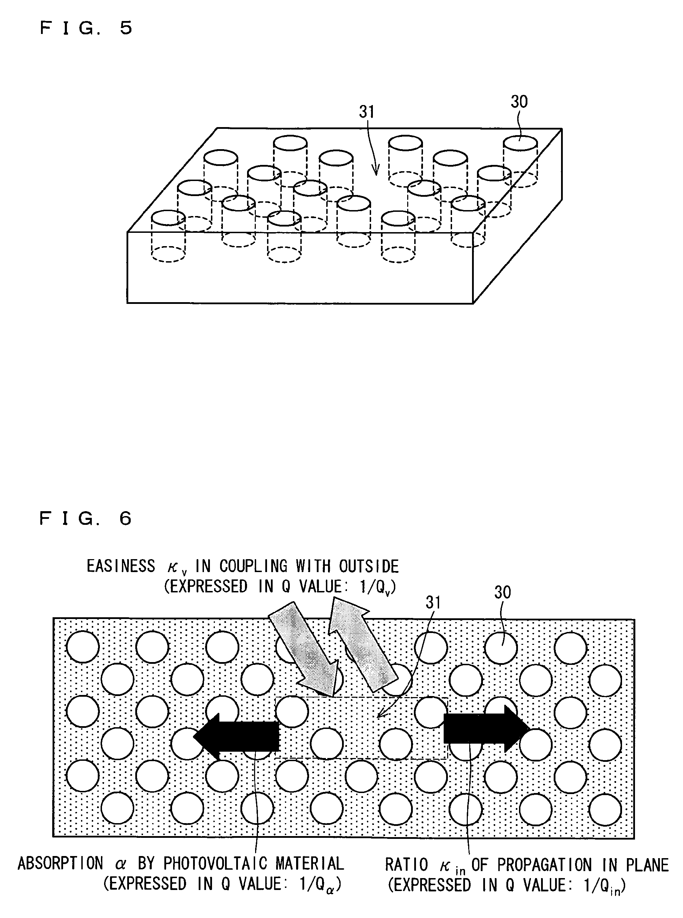

Fig. 5 is a perspective view showing a photoelectric conversion layer in which a photonic crystal is provided.
Fig. 6
Fig. 6 is a view explaining a relation between a magnitude of coupling of a photovoltaic device having a photonic crystal and a Q value.
Fig. 7

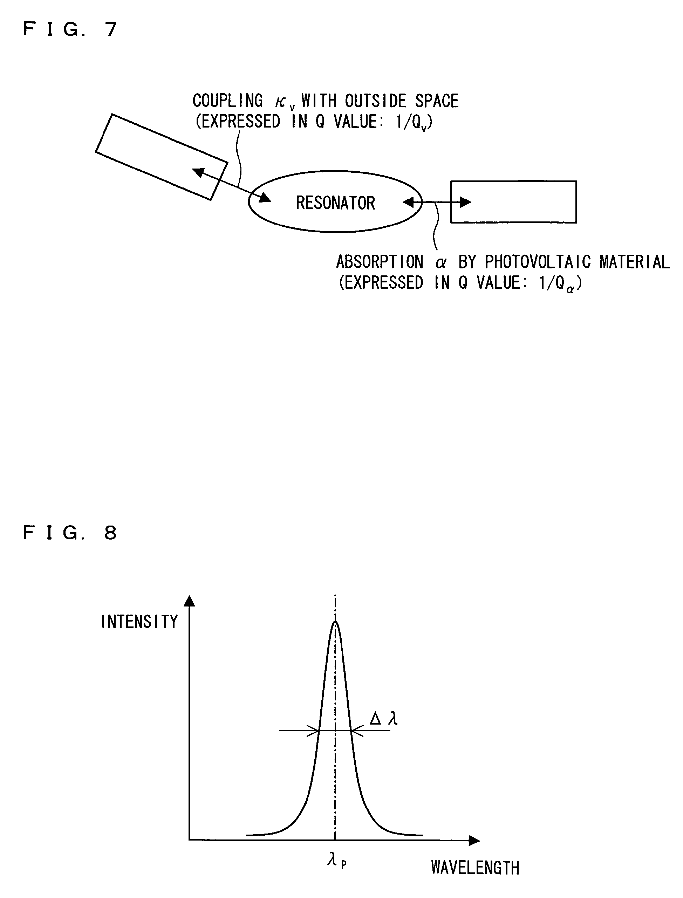

Fig. 7 is a view explaining a Q value of a resonator made of a defect in a photonic crystal.
Fig. 8
Fig. 8 is a graph showing a resonance peak of light in terms of a wavelength and strength.
Fig. 9

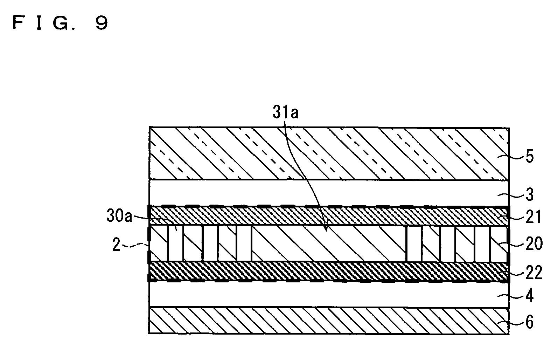

Fig. 9 is a cross sectional view schematically showing another configuration example of a photoelectric conversion element.
Fig. 10

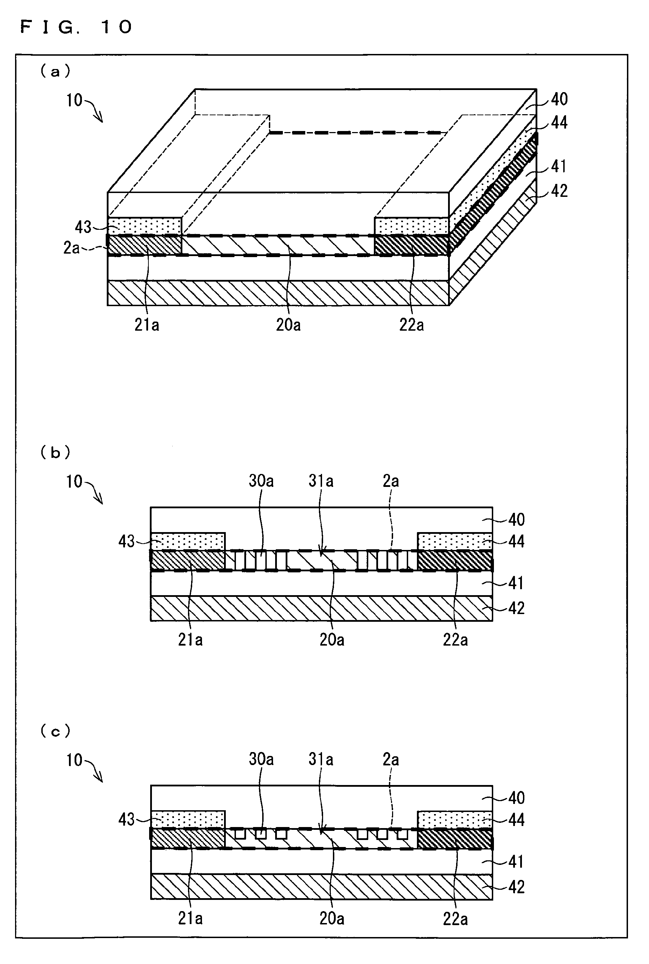

Fig. 10 is a cross sectional view schematically showing still another configuration example of a photoelectric conversion element.
Fig. 11

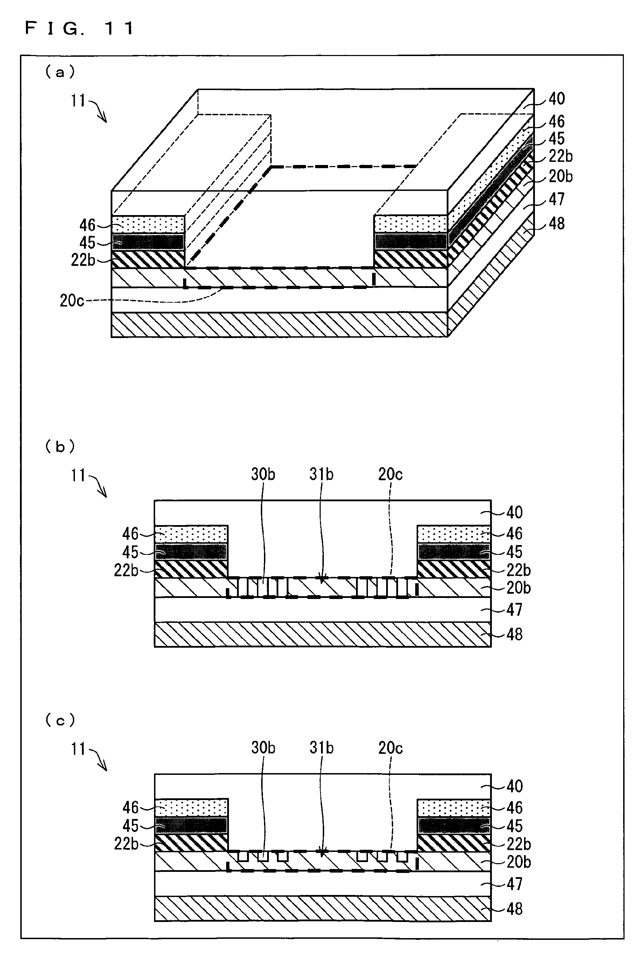

Fig. 11 is a cross sectional view schematically showing still another configuration example of a photoelectric conversion element.
Fig. 12

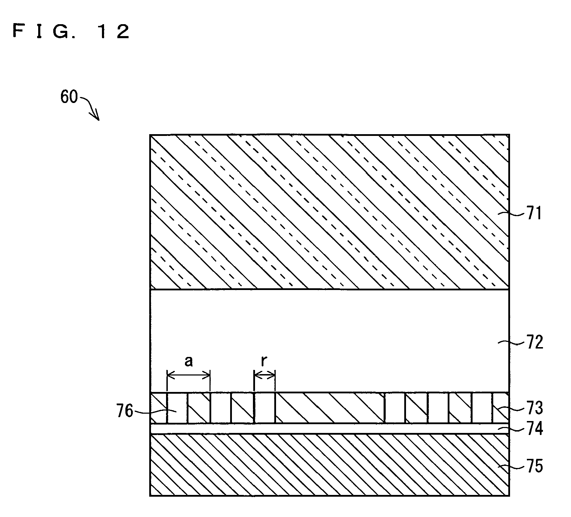

Fig. 12 is a cross sectional view showing a laminate structure of a photoelectric conversion element as Example 1.
Fig. 13

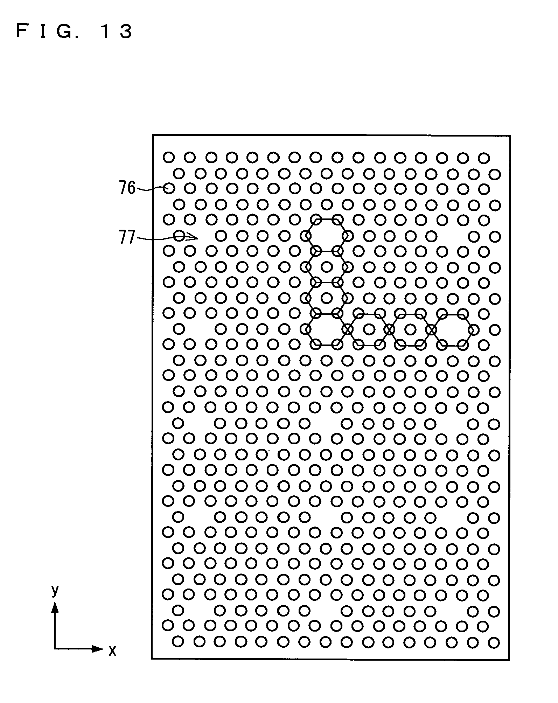

Fig. 13 is a plan view showing a two-dimensional arrangement of nanorods and defects (cavities) in a photonic crystal provided in a photoelectric conversion element.
Fig. 14

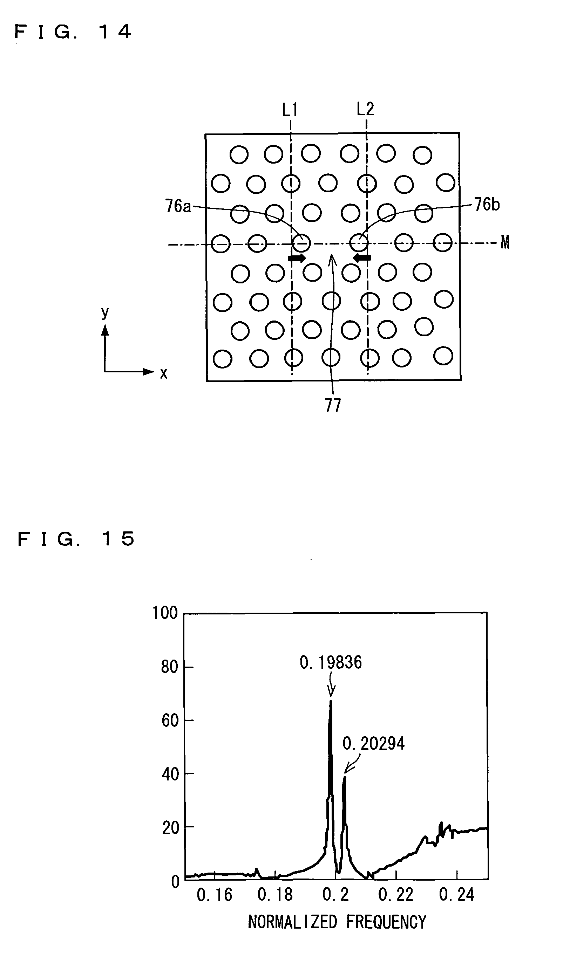

Fig. 14 is an explanatory plan view showing an intentional disarrangement in a periodic structure of nanorods surrounding a defect in a photonic crystal.
Fig. 15
Fig. 15 is a graph showing, in terms of a relation between normalized frequency and light intensity, a resonance occurring at a defect in a photonic crystal provided in the photoelectric conversion element of Example 1.
Fig. 16

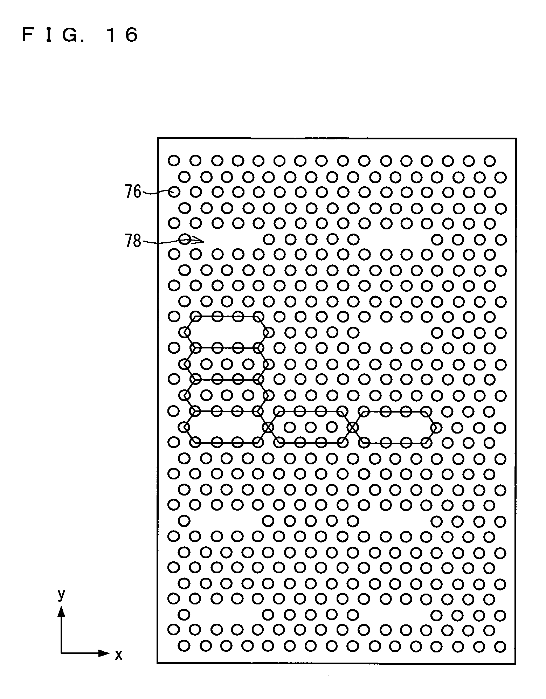

Fig. 16 is a plan view showing another two-dimensional arrangement (Example 2) of nanorods and defects in a photonic crystal provided in a semiconductor layer having the same laminate structure as that of Example 1.
Fig. 17

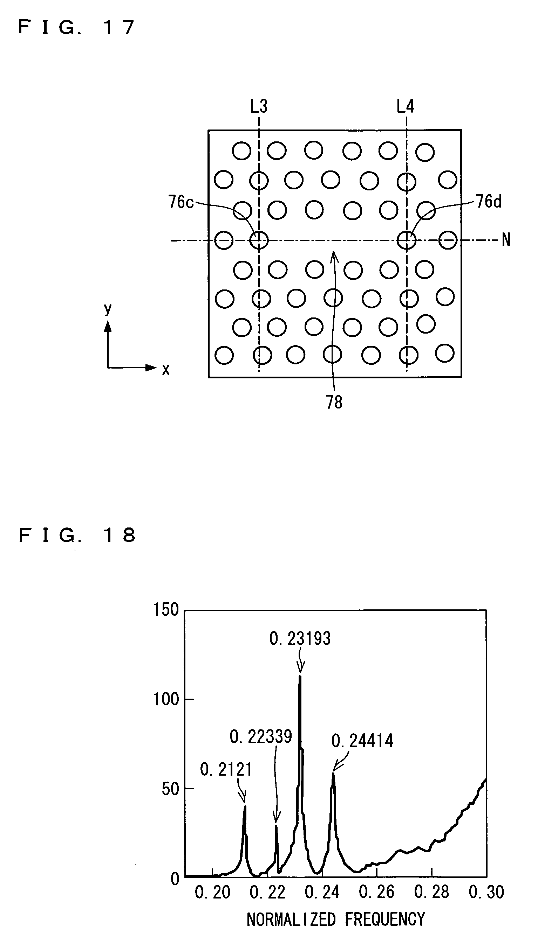

Fig. 17 is an explanatory plan view showing enlarged one of defect regions shown in Fig. 16.
Fig. 18
Fig. 18 is a graph showing, in terms of a relation between normalized frequency and light intensity, a resonance occurring at a defect region in a photonic crystal provided in the photoelectric conversion element of Example 2.
Fig. 19

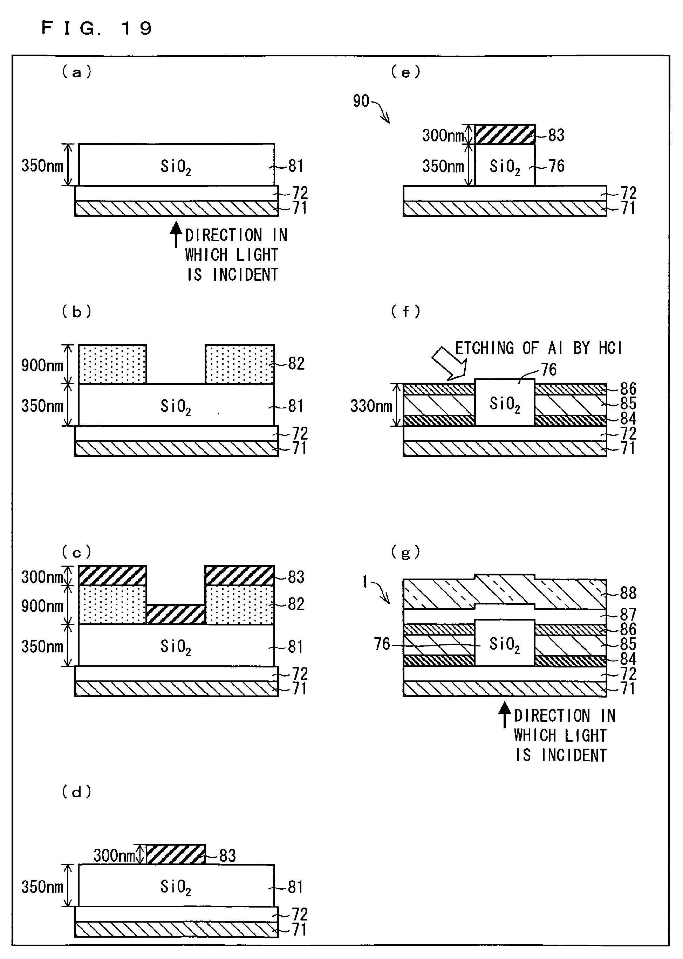

Fig. 19 is a process drawing showing a process for manufacturing a photoelectric conversion element.
Fig. 20
Fig. 20 is a graph showing a light absorption ratio of a-Si with respect to a wavelength of light.
Fig. 21

Fig. 21 is a view schematically showing a configuration of a conventional solar cell having a photonic crystal.

Description of Embodiments

The following explains an embodiment of the present invention with reference to Figs. 1 to 11. It should be noted that sizes, materials, shapes, relative positions etc. of members described in the embodiment serve solely as examples and are not intended to limit the scope of the present invention, unless otherwise specified.

(Configuration example 1 of photoelectric conversion element)

Fig. 1 is a view schematically showing a whole configuration of a photoelectric conversion element 1 in accordance with the present embodiment. (a) of Fig. 1 shows a perspective view of the photoelectric conversion element 1, and (b) and (c) of Fig. 1 show cross sectional views of the photoelectric conversion element 1.

The photoelectric conversion element 1 is an element for converting incident light to a current by photoelectric conversion. The photoelectric conversion element 1 can be used as a device for converting light into an electric signal.

The photoelectric conversion element 1 includes a photoelectric conversion layer 2 in which a photonic crystal is provided, transparent conductive layers 3 and 4 which sandwich the photoelectric conversion layer 2 from the above and below, a glass substrate 5 for covering the transparent conductive layer 3 at a side where light is incident, and a metal electrode layer 6 for covering the transparent conductive layer 4 at a side opposite to the side where light is incident, i.e. at a back side. The metal electrode layer 6 is positioned at the outermost layer opposite to the side where light is incident to the photoelectric conversion element 1. The transparent conductive layer 3 is one of two layers made of a medium whose refractive index is smaller than that of the medium of the photoelectric conversion layer 2, and the transparent conductive layer 4 is the other of the two layers.

The photoelectric conversion layer 2 has a structure in which semiconductor layers with different polarities are positioned adjacently to each other. In the present invention, the structure of the photoelectric conversion layer 2 is not particularly limited. For example, as shown in (b) and (c) of Fig. 1, the photoelectric conversion layer 2 may have a pin vertical structure in which an intrinsic semiconductor layer (i layer) 20 is sandwiched by a p-semiconductor layer 21 and an n-semiconductor layer 22.

To be more specific, the materials for the transparent conductive layers 3 and 4 may be ITO (Indium Tin Oxide), ZnO, $SnO_2$ etc. The glass substrate 5 may be glass whose refractive index is approximately 1.52 for example. Furthermore, the material for the metal electrode layer 6 may be one having a high light reflectance and a large electric conductivity, such as Ag and Al.

Light incident to the photoelectric conversion layer 2 via the glass substrate 5 generates, mainly at the intrinsic semiconductor layer 2, electrons and electron holes, and excites the electrons from a valence band to a conduction band, so that the light is absorbed by the intrinsic semiconductor layer 20. The excited electrons become a current that flows in a circuit including the transparent conductive layer 3, the metal electrode layer 6, and an external resistor 7, thereby generating a photovoltaic power at the external resistor 7.

The metal electrode layer 6 may also serve as a reflective plate. The metal electrode layer 6 can reflect light having been transmitted by the photoelectric conversion layer 2 without photoelectric conversion, so that the light travels to the photoelectric conversion layer 2 again. By providing the metal electrode layer 6 in such a manner as to cover the whole back surface of the photoelectric conversion element 1, it is possible to surely reflect light having been transmitted by the photoelectric conversion layer 2, so that the photoelectric conversion element 1 can have a high light absorption ratio.

As shown in the perspective view of Fig. 5, the photonic crystal provided in the photoelectric conversion layer 2 is a two-dimensional photonic crystal obtained by periodically arranging a plurality of nanorods (columnar mediums) 30 in the medium of the photoelectric conversion layer 2 having a thickness substantially corresponding to the wavelength of light. The nanorod 30 is made of a medium whose refractive index is smaller than that of the medium of the photoelectric conversion layer 2, and has a columnar shape for example. In a case where the medium of the photoelectric conversion layer 2 is, for example, amorphous silicon (a-Si) whose refractive index is approximately between 3 and 4, the medium of the nanorod 30 may be air or $SiO_2$ whose refractive index is 1.45. Besides, the material for the nanorod 30 may be JAS (transparent resin material) whose refractive index is approximately 1.6, or HSQ (Hydrogen Silsesquioxane) used as a SOG (Spin-on Glass) material. For example, FOX® (manufactured by Dow Corning Toray) etc. may be used as the HSQ.

Alternatively, the medium of the photoelectric conversion layer 2 may be microcrystalline silicon (μC-Si), Si, Ge, GaNINGaP, (In)GaAs, GaAs etc.

The distance for positioning the nanorods 30, i.e. the pitch (distance) p for the nanorods 30 is preferably shorter than the wavelength λ of light, and more preferably not less than λ/7 and not more than λ/2, in consideration of appropriately providing a later-mentioned photonic band gap. The wavelength λ is a wavelength of light which is confined and resonated inside the photonic crystal, to be more specific, a wavelength indicative of a resonance peak of the light.

The height of the nanorod 30 may be equal to the thickness of the photoelectric conversion layer 2 as shown in (b) of Fig. 1, or may be smaller than the thickness of the photoelectric conversion layer 2 as shown in (c) of Fig. 1. To be more specific, the height of the nanorod 30 is approximately not less than 1/4 and not more than 1/1 of the thickness of the photoelectric conversion layer 2.

In the example shown in (b) of Fig. 1, the nanorod 30 penetrates the p-semiconductor layer 21, the intrinsic semiconductor layer 20, and the n-semiconductor layer 22 and thus has a height equal to the thickness of the photoelectric conversion layer 2. On the other hand, in the example shown in (c) of Fig. 1, the height of the nanorod 30 is such that the nanorod 30 penetrates the p-semiconductor layer 21 and reaches the middle of the thickness of the intrinsic semiconductor layer 20.

Furthermore, the radius of the nanorod 30 is preferably not less than 0.2a (0.4a in diameter) and not more than 0.4a (0.8a in diameter) based on a pitch a as a reference.

As shown in (b) and (c) of Fig. 2, the cross section of the nanorod 30 may be a column or a rectangular column whose top and bottom are identical, or may be a truncated pyramid or a truncated cone whose top and bottom are not identical.

(Photonic band structure)

The photonic crystal configured as above has a photonic band structure as shown in Fig. 3. Fig. 3 is a graph showing a photonic band structure in terms of a relation between a direction in which light is incident to the photonic crystal and normalized frequency. The graph is obtained by connecting points plotted by using a relation between normalized frequencies and directions in which the light is incident. The normalized frequencies correspond to the wavelengths of light entering and resonated in the photonic crystal.

To be more specific, a low dielectric band resulting from the medium of the nanorod 30 and a high dielectric band resulting from the medium of the photoelectric conversion layer 2 are generated.

The photonic band structure has a photonic band gap g between the low dielectric band and the high dielectric band. The photonic band gap g is a wavelength band of light which cannot exist in the photonic crystal (band gap).

The normalized frequency is used as a parameter because the pitch a of the photonic crystal is related to the frequency of light, and is represented by $a/\lambda$. Accordingly, in Fig. 3, the wavelength is smaller as the scale mark of the graph is closer to the top of the longitudinal axis of the graph.

As shown in Fig. 4, the direction in which light is incident is indicated by a direction of a crystal which is represented by a reciprocal lattice space vector of a triangular lattice (two-dimensional plane portion of a hexagonal close-packed structure in crystal engineering). This is because a lattice arrangement sensed by light is an arrangement represented by a reciprocal lattice space (first Brillouin zone).

In Fig. 3, the point K indicates one corner of a hexagonal lattice surrounding the point $\Gamma$, and a point between the corner and adjacent corner is the point M. r indicates a direction in which light travels from directly above to the surface of the photonic crystal. K and M are used to indicate in-plane direction. In-plane directions are indicated by a combination of a starting point and an end point, such as $\Gamma$M, MK, and K$\Gamma$.

A triangle having $\Gamma$, K, and M at its corners is a unit lattice. A hexagon includes 12 unit lattices. When the direction of one unit lattice is determined, directions of the remaining unit lattices can be determined. For example, in a high dielectric band, the normalized frequency corresponding to M in Fig. 3 is approximately 0.2, which indicates that light that can be propagated in an in-plane direction of $\Gamma$M is only light with a wavelength corresponding to the normalized frequency of 0.2.

(Defect level)

Next, as shown in (b) and (c) of Fig. 1, (a)-(c) of Fig. 2, and Figs. 5 and 6, by forming a region where the nanorods 30 are not provided, i.e. defect 31 (also referred to as cavity or nanocavity) in the periodic structure of the nanorods 30, a defect level c is provided in the photonic band gap g. Light with a wavelength band (allowed band) corresponding to the defect level c is allowed to exist in the defect 31 whereas not allowed to exist in the photonic crystal surrounding the defect 31. As a result, the defect 31 serves as a micro resonator in which light with a wavelength band corresponding to the defect level c is confined.

The defect 31 may be provided by a one lattice point defect method to provide a region that lacks one nanorod 30 as shown in (a) of Fig. 2 or by a three lattice point linear defect method to provide a region that lacks three nanorods 30 in a linear manner as shown in Fig. 16 etc.

The photonic crystal made of the nanorods 30 and the defect 31 as above has no polarization characteristic etc. in a specific direction. For that purpose, the structure of the photonic crystal is symmetrical basically in every cross section. It is desirable that an electromagnetic field resulting from the structure is concentric.

(Design of photonic crystal based on Q value)

Here, the magnitude of coupling in light between the outside of the photonic conversion element 1 and the photonic crystal is discussed in terms of a Q value. Similarly with a Q value regarding resonance in electric engineering, the Q value here represents the magnitude of a resonance effect of light as electromagnetic waves. The Q value may be represented in various ways, and may be represented by equation 1 or 2 below.

$$Q = \lambda p / \Delta\lambda \qquad \dots \text{equation 1}$$

$$Q = \omega U / (-dU/dt) \qquad \dots \text{equation 2}$$

Fig. 8 is a graph showing a resonance peak of light in terms of a relation between wavelength and intensity of light. As shown in Fig. 8, $\lambda p$ in the equation 1 indicates the wavelength of the resonance peak, and $\Delta\lambda$ indicates a half bandwidth.

In the equation 2, $\omega$ indicates a resonant angular frequency, U indicates energy inside the resonator, and t indicates a time.

According to the equation 1, as the half bandwidth $\Delta\lambda$ is smaller, resonance is stronger, indicating that as resonance is stronger, the Q value is larger. Furthermore, as resonance is stronger, the amplitude of the resonance is larger and waves are less likely to decay, indicating that as the Q value is larger, a time during which light exists in the resonator (life time) is longer.

Furthermore, according to the equation 2, as the loss of energy from the resonator is smaller, i.e. -dU/dt is smaller, the Q value is larger. Accordingly, the Q value may be regarded as indicating the strength with which the resonator confines light.

When forming a photonic crystal in a laser diode etc., the photonic crystal is designed such that the Q value is set as large as possible in order to make resonance stronger and increase light emission intensity. However, in the present invention, contrary to the above, a photonic crystal is designed such that the Q value is set to be as small as possible in order that the wavelength band of light confined in the resonator is broadened (i.e. half bandwidth is broadened) and the life time of the light is shortened, enabling more amount of light to be absorbed by a semiconductor layer. Broadening the half bandwidth of light makes it easier to make coupling in light between the outside and the photonic crystal, shortening the life time of light.

Here, the defect 31 shown in Fig. 6 is regarded as the resonator shown in Fig. 7 and the Q value is discussed in terms of the whole system including the outer space and the medium of the base material of the photonic crystal (i.e. semiconductor constituting the photoelectric conversion layer 2). Assuming that the Q value of the photonic conversion element 1 as a whole is $Q_T$, the Q value regarding coupling between the photonic crystal and the outer space is $Q_V$, the Q value regarding propagation in an in-plane direction of the photonic crystal is $Q_{in}$, the Q value regarding absorption of light by the medium is $Q_\alpha$, and the Q value regarding absorption of light by the metal electrode layer 6 is $Q_M$, a relational expression (equation 3) below is met.

It should be noted that, as shown in equation 4 below, $Q\alpha$ mentioned above is proportional to an inverse number of a light absorption coefficient $\alpha$ of the base material of the photonic crystal.

$$1/Q_T = 1/Q_V + 1/Q_{in} + 1/Q_\alpha + 1/Q_M \qquad \dots \text{equation 3}$$

$Q_V$ is proportional to an inverse number of a coefficient $\kappa_V$ indicative of strength of coupling (easiness in coupling) between the photonic crystal and the outer space, and represents easiness in light emission to the outer space due to coupling between the photonic crystal and the outer space. When the structure of the photonic crystal is determined, it is possible to calculate Qv by FDTD (Finite Difference Time Domain). That is, Qv is a Q value determined by the structure of the photonic crystal.

$Q_{in}$ indicates easiness in horizontal propagation of light having entered the photonic crystal. Accordingly, in terms of confinement of light, $Q_{in}$ indicates easiness in leakage of light from the resonator without being confined. $Q_\alpha$ and $Q_M$ indicate the magnitudes of resonance effects yielded respectively by the medium and the metal constituting the metal electrode layer 6 absorbing light. $Q_M$ can be obtained by measurement.

On the other hand, $Q\alpha$ has a relation represented by equation 4 below with the absorption coefficient $\alpha$ unique

to the medium, a refractive index n of the medium, and a wavelength $\lambda$ of a resonance peak. That is, $Q\alpha$ is a Q value determined by the material of the medium.

$$\alpha = 2\pi n / \lambda Q_\alpha \qquad \ldots \text{equation 4}$$

When $Q_V = Q_\alpha$ in the relational expression of the equation 3, in other words, when $\kappa_V = \alpha$, absorption of light by the medium is at maximum, and the wavelength band of the absorbed light is broadened at maximum.
Furthermore, when the resonance effect in the resonator is ideal and light does not leak into the plane of the optical semiconductor device, $Q_{in} = \infty$.
Consequently, equation (5) below is obtained.

$$Q_T = \pi \cdot n \cdot Q_M / (\lambda \cdot \alpha \cdot Q_M + \pi \cdot n) \qquad \ldots \text{equation 5}$$

Here, the Q value ($Q_T$) of the photonic conversion element 1 as a whole in which the photonic crystal is designed to meet a relation $Q_V = Q_\alpha$ is calculated specifically by the equation 5. Initially, assuming the medium to be a-Si, the refractive index n is 4.154 and the absorption coefficient $\alpha$ is 65534 $cm^{-1}$. Furthermore, assuming the wavelength $\lambda$ to be 660 nm and $Q_M$ of the metal to be 4000, $Q_T$ has a very small value below.

$$Q_T = 11.1$$

From the equation 1, $\Delta\lambda = 59.5$ nm is obtained, which is a very wide half bandwidth.
Accordingly, by designing the photonic crystal to meet the relation $Q_V = Q_\alpha$ (designing the radius of the nanorod 30, the pitch a for the nanorod 30 etc.), it is possible to make light confined in the defect 31 more easily absorbed by the medium, and to obtain a resonance effect in a wider wavelength range. In other words, the photonic conversion element of the present invention is a photonic conversion element in which a photoelectric conversion layer incudes a photonic crystal designed such that the Q value determined by the structure of the photonic crystal is equal to the Q value determined by the material of the medium of the photoelectric conversion layer including the photonic crystal.
An additional explanation is made here as to a relation between the coefficient $\kappa_V$ and the absorption coefficient $\alpha$. Initially, since the photovoltaic material originally has a relatively high light absorption ratio, $\alpha$ tends to be large and $Q\alpha$ tends to be small in reverse.
On the other hand, in a case where a photonic crystal is provided in the photovoltaic material, since refractive index of the photovoltaic material is generally higher by 1 or more than that of nanorods, providing the photonic crystal without any modification tends to make the coefficient kv smaller and reversely make Qv larger. Therefore, by nature, a relation $k_V \leq \alpha$ ($Qv \geq Q_\alpha$) is met.
For the purpose of increase in light absorption by the photovoltaic device, which is a goal to be achieved by the present invention, it is necessary that light coupled to the resonator made of the defect in the photonic crystal is subjected to an absorption process by the photovoltaic device. This effect is maximized when $\kappa_V = \alpha(Qv = Q_\alpha)$.
In view of the above, in order to increase light absorption by the photovoltaic device, it is necessary to meet the relation $\kappa_V = \alpha(Qv = Q_\alpha)$, which requires making $\kappa_V$ larger (making Qv smaller). In order to make $\kappa_V$ larger (make Qv smaller), it is necessary to increase the ratio of coupling of the resonator as a whole constituted by the photonic crystal (device as a whole) (decrease the Q value of the photovoltaic device, i.e. $Q_T$ mentioned above).
A more detailed discussion can be made in consideration of the aforementioned mode coupling theory. Specifically, when the thickness of a transparent layer corresponding to the transparent conductive layer 4 in the photonic conversion element 1 meets a relation $\theta = 2mn$ (m = 0, 1, 2 ...), Pv indicative of the ratio of optical energy absorbed by the optical semiconductor layer is represented by an equation below.

$$P_V = (8 \cdot Q_\alpha / Q_V) / (1 + 2Q_\alpha / Q_M + 2Q_\alpha / Q_V)^2$$

It can be concluded from this relational expression that in order to use 90 % or more of light, it is desirable to design a photonic crystal structure to meet a relation $0.2 Qv \leq Q_\alpha \leq 5.4 Qv$.

(Configuration example 2 of photonic conversion element)

Fig. 9 is a cross sectional view schematically showing another configuration example of the photonic conversion element 1. A difference between the present configuration example and the configuration of the photonic conversion element 1 described with reference to Fig. 1 lies in that a photonic crystal is provided inside the intrinsic semiconductor layer 20 in the present configuration example.

As shown in Fig. 9, a plurality of nanorods 30a are arranged two-dimensionally and periodically in the intrinsic semiconductor layer 20, and there is provided a defect 31a where the nanorods 30a are not provided partially.

As already described, light incident to the photoelectric conversion layer 2 generates, mainly at the intrinsic semiconductor layer 2, electrons and electron holes, and excites the electrons from a valence band to a conduction band, so that the light is absorbed by the intrinsic semiconductor layer 20. Accordingly, by providing a photonic crystal at least in the intrinsic semiconductor layer 20, it is possible to enhance efficiency in photoelectric conversion.

(Configuration example 3 of photoelectric conversion element)

Fig. 10 is a view schematically showing a whole configuration of a photoelectric conversion element 10 as another configuration example. (a) of Fig. 10 shows a perspective view of the photoelectric conversion element 10, and (b) and (c) of Fig. 10 show cross sectional views of the photoelectric conversion element 10.

The photoelectric conversion element 10 includes a photoelectric conversion layer 2a in which a photonic crystal is provided, a passivasion film 40 which is laminated on a light-incident side of the photoelectric conversion layer 2a and which serves as one of dielectric layers sandwiching the photoelectric conversion layer 2a, an insulating layer 41 which covers a back surface of the photoelectric conversion layer 2a and which serves as the other of the dielectric layers, and a reflective film 42 which covers a back surface of the insulating layer 41. The passivasion film 40 is one of two layers made of a medium whose refractive index is smaller than that of the medium of the photoelectric conversion layer 2a, and the insulating layer 41 is the other of the two layers.

The photoelectric conversion layer 2a has a pin lateral structure instead of the pin vertical structure shown in Fig. 1. That is, the photoelectric conversion layer 2a has a structure in which a p-semiconductor layer 21a, an intrinsic semiconductor layer (i-layer) 20a, and an n-semiconductor layer 22a are laterally adjacent to each other in this order.

The lateral structure is advantageous for thinning the photoelectric conversion element. Besides, the lateral structure has a merit of higher sensing speed (optical response speed) than that of the vertical structure since the lateral structure has a less amount of overlapping layers than the vertical structure and consequently smaller parasitic capacitance between the layers.

On light-incident sides of the p-semiconductor layer 21a and the n-semiconductor layer 22a, electrodes 43 and 44 for taking out a power are laminated, respectively, and consequently the upper surface of the intrinsic semiconductor layer 20a serves as a light-receiving surface. Accordingly, when the passivasion film 40 and the insulating film 41 sandwiching the intrinsic semiconductor layer 20a in which the photonic crystal is provided is designed such that at least the passivation film 40 is transparent, it is possible to let the photonic crystal to take light in.

The photonic crystal is a two-dimensional slab photonic crystal obtained by periodically arranging a plurality of nanorods 30a in the intrinsic semiconductor layer 20a having a thickness approximately corresponding to the wavelength of light. The height of the nanorods 30a may be equal to the thickness of the intrinsic semiconductor layer 20a as shown in (b) of Fig. 10 or may be smaller than the thickness of the intrinsic semiconductor layer 20a as shown in (c) of Fig. 10. To be more specific, the height of the nanorods 30 is approximately not less than 1/4 and not more than 1/1 of the thickness of the intrinsic semiconductor layer 20a.

Furthermore, the periodic structure of the nanorods 30a (pitch a for the nanorods 30a is equal to pitch a for the nanorods 30) has a defect 31a serving as a region where the nanorod 30a is not provided in order to provide a defect level in a photonic band gap, similarly with the defect 31.

The passivasion film 40 is made of a dielectric material whose refractive index is approximately between 1.2 and 2.0, which is smaller than the refractive index of the medium of the photoelectric conversion layer 2a (e.g. a-Si). The dielectric material may be an inorganic insulating material such as $SiO_2$ and SiNx. The insulating layer 41 may be made of the same material as that of the passivasion film 40.

The passivasion film 40 prevents recombination of carriers at the light-receiving surface of the photoelectric conversion layer 2a. For example, $H_2$ gas generated when forming a $SiO_2$ film or a SiNx film by plasma CVD (Chemical Vapor Deposition) plays an important role in preventing recombination of carriers. This is because many of dangling bonds of silicon at the light-receiving surface of the photoelectric conversion layer 2a bind to hydrogen and consequently concentration of the recombination center drops, resulting in a longer lifetime of electrons and electron holes generated by light radiation.

The reflective film 42 reflects light having been transmitted by the photoelectric conversion layer 2a and the insulating layer 41 so that the light travels to the photoelectric conversion layer 2a. The material of the reflective film 42 may be a metal material having high light reflectance and low light absorption, such as Mo and Al.

With the arrangement, electric charge mainly generated by photoexcitation at the intrinsic semiconductor layer 20a becomes a current that flows in a circuit constituted by an electrode 43 on the p-semiconductor layer 21a, an electrode 44 on the n-semiconductor layer22a, and an external resistor, thereby generating a photovoltaic power at the external resistor.

The reflective film 42 is provided for reflecting light having been transmitted by the photoelectric conversion layer 2a out of light having been incident via the light-incident surface of the photoelectric conversion element 10 so that the reflected light travels to the photoelectric conversion layer 2a again. For this reason, it is preferable that the reflective film 42 covers the whole back surface of the photoelectric conversion element 10.

(Configuration example 4 of photoelectric conversion element)

Fig. 11 is a view schematically showing a whole configuration of a photoelectric conversion element 11 as still another configuration example. (a) of Fig. 11 shows a perspective view of the photoelectric conversion element 11, and (b) and (c) of Fig. 11 show cross sectional views of the photoelectric conversion element 11.

The photoelectric conversion element 11 has an nin structure in which n-semiconductor layers 22b are respectively laminated on two end portions facing in a rectangular intrinsic semiconductor layer 20b, which is the same structure as that of a TFT having a-Si as a semiconductor layer. On the two end portions of the n-semiconductor layer 22b, there are laminated electrodes for taking out a power, respectively. Consequently, a central portion of the upper surface of the intrinsic semiconductor layer 20b on which central portion the n-semiconductor layer 22b is not provided serves as a light-receiving surface.

Accordingly, a photonic crystal is provided inside a partial region 20c of the intrinsic semiconductor layer 20b below the light-receiving surface. Nanorods 30b and defects 31b constituting the photonic crystal have the same configurations as those of the nanorods 30a and the defects 31a.

The electrode laminated on the n-semiconductor layer 22b has a two-layered structure made of an ITO electrode 45 and a metal electrode 46. This is because when Si is used for the photoelectric conversion layer 2a, a metal layer cannot be directly formed on the Si and so requires formation of the ITO electrode 45 on the Si. By designing the electrode to have a two-layered structure made of the ITO electrode 45 and the metal electrode 46, it is possible to prevent migration of the metal electrode 46 from reducing insulation resistance between the electrodes and to reduce resistance of the whole electrodes.

On the back surface of the intrinsic semiconductor layer 20b, an insulating layer 47 serving similarly with a gate insulating film of a TFT is provided, and a metal electrode layer 48 serving similarly with a gate electrode of a TFT covers the back surface of the insulating layer 47. The metal electrode layer 48 may be made of Ti, Al etc.

With the arrangement, electric charge mainly generated by photoexcitation at the intrinsic semiconductor layer 20b becomes a current that flows in a circuit constituted by the metal electrode 46 on both sides of the intrinsic semiconductor layer 20b and an external resistor, thereby generating a photovoltaic power at the external resistor.

In a case of providing a photonic crystal in an optical sensor whose phototransistor is an inversely staggered TFT (Thin Film Transistor), the photonic crystal should be provided in a semiconductor layer so as to be at a portion above a gate electrode. Light reaching the gate electrode out of light incident to the TFT is reflected by the gate electrode and travels to the photonic crystal again. This configuration increases the photovoltaic power of the sensor.

[Examples]

(Example 1)

The following explains an example of the photoelectric conversion element with reference to Figs. 12 to 15.

Fig. 12 is a cross sectional view showing a laminate structure of a photoelectric conversion element 60 as Example 1. Fig. 13 is a plan view showing a two-dimensional arrangement of nanorods and defects (nanocavities) in a photonic crystal provided in the photoelectric conversion element 60.

The photoelectric conversion element 60 includes a glass substrate 71, a transparent conductive layer 72 made of ZnO, a semiconductor layer 73 having a pin connection structure of a-Si, a transparent conductive layer 74 made of ZnO, and a metal electrode layer 75 made of Al which are laminated in this order from a light-receiving surface of the solar cell 60. The transparent conductive layers 72 and 74 may be made of $SnO_2$.

Refractive indices of the glass substrate 71, the transparent conductive layer 72, the semiconductor layer 73, and the transparent conductive layer 74 are 1.52, 2.0, 3.76, and 2.0, respectively. The semiconductor layer 73 having high refractive index in which the photonic crystal is provided is sandwiched by the transparent conductive layers 72 and 74 having low refractive indices.

Furthermore, the thicknesses of the transparent conductive layer 72, the semiconductor layer 73, the transparent conductive layer 74, and the metal electrode layer 75 are 900 nm, 330 nm, 60 nm, and 100 nm, respectively.

The transparent conductive layer 72, the semiconductor layer 73, the transparent conductive layer 74, and the metal electrode layer 75 are sequentially evaporated and formed on the glass substrate 71 in such a manner as to have the above thicknesses, respectively.

As described with reference to Fig. 1 etc., in the semiconductor layer 73, columnar nanorods 76 whose diameter r is 60 nm are arranged two-dimensionally with a pitch of 200 nm. The nanorods 76 are made of $SiO_2$ whose refractive index is 1.45.

As shown in Fig. 13, assuming that the nanorods 76 are positioned at corners and a center of each of a plurality of hexagons consisting of triangular lattices on a plan view and the plurality of hexagons are referred to as first units (indicated by thin lines in Fig. 13), since the pitch for the nanorods 76 is a, the first units are arranged two-dimensionally with a pitch of 2a in an x-direction and √3a in a y-direction perpendicular to the x-direction, and defects 77 where the nanorods 76 are not provided are arranged in a square lattice manner with a pitch of 4a to 8a in an x-direction and 2√3a to 4√3a in a y-direction.

The pitches for positioning the first units and the defects 77 are further described below. For example, assuming that a distance between the centers of the hexagons constituting the first units which are adjacent to each other in the x-direction is Lx and a distance between the centers of the hexagons constituting the first units which are adjacent to each other in the y-direction is Ly, the first units are arranged two-dimensionally with a pitch of Lx = 2a in the x-direction and Ly = 2√3a in the y-direction. Therefore, the defects are arranged with a pitch of 2Lx to 4Lx in the x-direction and also 2Ly to 4Ly in the y-direction.

The arrangement in a square lattice manner mentioned above indicates an arrangement with the same pitch both in the x-direction and the y-direction. For example, when the defects 77 are arranged with a pitch of 2Lx in the x-direction and also 2Ly in the y-direction, the defects 77 are arranged in s square lattice manner.

The result of simulation by the FDTD method confirmed that when the defects 77 are arranged in a square lattice manner, resonances respectively generated in the defects 77 arranged on the whole light-receiving surface of the semiconductor layer 73 interact with each other.

As the area where resonances interact with each other is larger, the Q value ($Q_T$) of the photoelectric conversion element 60 as a whole is smaller. Furthermore, as the height of the nanorod 76 is smaller with respect to the thickness of the semiconductor layer73, the Q value ($Q_T$) is smaller, and consequently the coefficient $\kappa_V$ indicative of coupling with the outside is larger. Based on the above discussion, it is possible to increase the amount of light that can be absorbed by the photovoltaic layer (semiconductor layer 73).

Furthermore, as shown in Fig. 14, there was carried out a simulation in which among the nanorods 76 surrounding the defect 77, two nanorods 76a and 76b positioned on a line M extending in a specific direction (x-direction) were shifted oppositely to each other from the corners of the hexagon (indicated by lines L1 and L2) in the specific direction so that a distance between the two nanorods 76a and 76b were shorter.

The result of the simulation by the FDTD method showed that disarranging the periodic structure of the nanorods 76 surrounding the defect 77 allows splitting degeneracy of a resonance peak of light confined and resonated inside the defect 77. The result of the simulation is shown in Fig. 15. Fig. 15 is a graph showing, in terms of a relation between normalized frequency and light intensity, a resonance effect yielded by the defect 77 of the photonic crystal provided in the photoelectric conversion element 60 of the Example 1. As shown in Fig. 15, there are two resonant points for one defect (cavity of 1 dot).

(Example 2)

Next, the following explains another example of the photoelectric conversion element with reference to Figs. 16 to 18.

Fig. 16 is a plan view showing another two-dimensional arrangement of nanorods and defects in a photonic crystal provided in a semiconductor layer 73 having the same laminate structure as that of the photoelectric conversion element 60.

As shown in Fig. 16, assuming that the nanorods 76 are positioned at corners and a center of each of a plurality of hexagons consisting of triangular lattices and there is provided a defect region 78 including the defects in the number of at least two (e.g. three lattice point linear defect that lacks three nanorods in Fig. 16) in the plurality of hexagons on a plan view and the plurality of hexagons are referred to as second units (indicated by thin lines in Fig. 16), since the pitch for the nanorods 76 is a, the second units are arranged two-dimensionally with a pitch of 4a or more in an x-direction and √3a in a y-direction, and the defects are arranged in a square lattice manner with a pitch of 4a to 8a in an x-direction and 2√3a to 4√3a in a y-direction.

The result of the simulation by the FDTD method showed that also by continuously providing two or more defects in one unit, it is possible to split degeneracy of a resonance peak of light confined and resonated in the defect region 78. The result is shown in Fig. 18. Fig. 18 is a graph showing, in terms of a relation between normalized frequency and light intensity, a resonance occurring at the defect region 78. As shown in Fig. 18, there appears three resonant points by the three lattice point linear defect.

(Process for manufacturing photoelectric conversion element)

Lastly, a detailed explanation is made as to a process for manufacturing the photoelectric conversion element 60 of the Example 1. Fig. 19 is a process drawing showing the process for manufacturing the photoelectric conversion element 60.

Initially, as shown in (a) of Fig. 19, $SnO_2$ is evaporated on the glass substrate 71 to form the transparent conductive layer 72, and then $SiO_2$ from which the nanorods 76 are to be made is evaporated on the transparent conductive layer 72 to have a thickness of 350 nm, so that an $SiO_2$ layer 81 is formed.

Next, as shown in (b) of Fig. 19, a photoresist 82 is applied onto the $SiO_2$ layer 81 to have a thickness of 900 nm, and then patterns corresponding to positioning patterns of the nanorods 76 and the defects 77 are drawn by exposure to an electron beam. In a case where the photoresist 82 is a positive photosensitive material, the exposed portion is removed by development to form the positioning patterns of the nanorods 76 and the positioning patterns of the defects 77, each defined by the pitch a of 150 to 250 nm and the diameter r of 60 nm.

Subsequently, as shown in (c) of Fig. 19, Al is evaporated on the whole of the positioning patterns to have a thickness of 300 nm, so that an Al film 83 is formed.

Thereafter, as shown in (d) of Fig. 19, the photoresist 82 is removed so that the Al film 83 remains only at the portions where the nanorods 76 are formed. The $SiO_2$ layer 81 maintains the thickness of 350 nm.

Furthermore, as shown in (e) of Fig. 19, using the remaining Al film 83 as a mask, the unmasked $SiO_2$ is removed precisely by ICP-RIE (Inductive Coupled Plasma-Reactive Ion Etching) using carbon tetrafluoride ($CF_4$) as an etching gas. Thus, an intermediate 90 where the nanorods 76 are arranged two-dimensionally on the transparent conductive layer 72 is prepared.

Next, as shown in (f) of Fig. 19, a-Si is evaporated on the whole surface of the intermediate 90 and is doped with a p-impurity to form a p-a-Si layer 84, and a-Si is evaporated thereon to form i-a-Si layer 85, and a-Si is evaporated thereon and is doped with n-impurity to form an n-a-Si layer 86. The total thickness of the a-Si layers 84 to 86 is controlled to be approximately 330 nm, so that upper portions of the nanorods 76 with a thickness of 350 nm slightly protrude from the top surface of the n-a-Si layer 86.

Furthermore, each of the a-Si layers 84 to 86 has a thickness which is thinner by approximately 1/3 times or more than the total of the thickness of the nanorods 76 (350 nm) and the thickness of the Al film 83 thereon (300 nm), so that each of the a-Si layers 84 to 86 is separated into a portion formed on the transparent conductive layer 72 and a portion formed on the Al film 83. That is, the Al film 83 remaining on the nanorods 76 is exposed without its sides covered by a-Si.

Subsequently, the remaining Al film 83 is removed by wet etching using hydrochloric acid (HCl). Since the Al film 83 remaining on the nanorods 76 exposes its sides, it is possible to remove the Al film 83 by wet etching.

Lastly, as shown in (g) of Fig. 19, $SnO_2$ is evaporated to form a transparent conductive layer 87 and a metal electrode layer 88 is laminated, so that the photoelectric conversion element 1 is completed. A portion of the transparent conductive layer 87 and a portion of the metal electrode layer 88 which portions are positioned above the nanorod 76 slightly protrude upward since the portions reflect a slight protrusion of the nanorod 76 from the top surface of the n-a-Si layer 86.

The present invention is not limited to the description of the embodiments above, but may be altered by a skilled person within the scope of the claims. An embodiment based on a proper combination of technical means disclosed in different embodiments is encompassed in the technical scope of the present invention.

The following additionally explains features of the photoelectric conversion element of the present invention.

The photoelectric conversion element of the present invention is arranged such that the photonic crystal is designed such that the columnar mediums each have a height equal to a thickness of the photoelectric conversion layer.

The above arrangement is one example of a configuration of a two-dimensional photonic crystal that can be manufactured relatively easily by a publicly known semiconductor process technique. Furthermore, a two-dimensional photonic crystal with the above arrangement can efficiently confine, in and in the vicinity of the defects, light that is propagated in the photonic crystal along the surface.

Furthermore, when the height of the columnar mediums is equal to the thickness of the photoelectric conversion layer, a photonic band gap is more likely to be provided, so that it is easier to cause light to enter, without incident angle dependency, the photoelectric conversion layer, in other words, the photonic crystal. Therefore, the above arrangement is suitable for a photoelectric conversion element that is required to have as high a light absorption ratio as possible, such as a solar cell.

The photonic conversion element of the present invention may be arranged such that the photonic crystal is designed such that the columnar mediums each have a height smaller than a thickness of the photoelectric conversion layer.

The photoelectric conversion element of the present invention is arranged such that the columnar mediums are positioned at corners and a center of each of a plurality of hexagons consisting of triangular lattices on a plan view, and when the plurality of hexagons are referred to as first units and the pitch for the columnar mediums is a, the first units are provided two-dimensionally with a pitch of 2a in an x-direction and $\sqrt{3}$a in a y-direction, and the defects are provided in a square lattice manner with a pitch of 4a to 8a in an x-direction and $2\sqrt{3}$a to $4\sqrt{3}$a in a y-direction.

With the arrangement, the $\kappa_V$ and $\alpha$ (or Qv and $Q_\alpha$) are substantially equal to each other, so that light absorption by the medium of the photoelectric conversion layer can be at maximum and the wavelength band of the absorbed light can be at maximum. The defects can be considered as resonators that confine light. By arranging a plurality of resonators in a matrix manner, it is possible to cause the resonators to resonate with each other, thereby making the intensity of the whole resonance smaller (making Qv smaller = making $\kappa_V$ larger). This intensifies coupling between the photonic crystal and the outside, making it easier to take light in the photonic crystal. On the other hand, since the Q value of the photonic crystal is made smaller, light absorption by the photoelectric conversion layer is larger, and the wavelength band of the absorbed light can be broader.

The photoelectric conversion element of the present invention may be arranged such that the columnar mediums are positioned at corners and a center of each of a plurality of hexagons consisting of triangular lattices and the defects are provided in the number of at least two in the plurality of hexagons on a plan view, and when the hexagons having the at least two defects are referred to as second units and the pitch for the columnar mediums is a, the second units are provided two-dimensionally with a pitch of not less than 4a in an x-direction and $\sqrt{3}$a in a y-direction, and the defects are provided in a square lattice manner with a pitch of 4a to 8a in an x-direction and $2\sqrt{3}$a to $4\sqrt{3}$a in a y-direction.

Also in this case, the $\kappa_V$ and $\alpha$ (or Qv and $Q_\alpha$) are substantially equal to each other, so that the same effect as above can be yielded.

Furthermore, by providing at least two defects in the units in which the columnar mediums are positioned on the corners of a hexagon, degeneracy of a resonance peak is split and a plurality of resonant peaks with different wavelengths appear. Consequently, the wavelength band of the absorbed light is broadened, too.

The photoelectric conversion element of the present invention is arranged such that among the columnar mediums surrounding the defects, two columnar mediums positioned on a line extending in a specific direction are shifted oppositely to each other from the corners of the hexagon in the specific direction so that a distance between the two columnar mediums are shorter.

With the arrangement, periodic arrangement of the columnar mediums is disarranged, so that degeneracy of a resonance peak is split and a plurality of resonant peaks with different wavelengths appear. Consequently, the wavelength band of the absorbed light is broadened.

The photoelectric conversion element of the present invention is arranged such that the photoelectric conversion layer is interleaved between two layers each made of a medium whose refraction index is smaller than that of the medium of the photoelectric conversion layer, and at least one of the two layers is transparent.

With the arrangement, light that would be propagated in a direction normal to the surfaces of the photoelectric conversion layer and leak therefrom can be confined based on the same principle as that of optical fibers in which a core with a high refractive index is covered with a clad with a low refractive index. Consequently, it is possible to further increase the light absorption ratio of the photoelectric conversion layer.

In order that light enters the photonic crystal, at least one of the two layers which one is closer to the light-receiving surface of the photonic conversion element is preferably transparent.

The photoelectric conversion element of the present invention is arranged such that the photoelectric conversion layer has an adjacency structure in which a p-semiconductor layer, an intrinsic semiconductor layer, and an n-semiconductor layer are positioned adjacently to each other or an adjacency structure in which an n-semiconductor layer, an intrinsic semiconductor layer, and an n-semiconductor layer are positioned adjacently to each other, and the adjacency structure is a vertical structure in which individual layers are laminated vertically or a lateral structure in which individual layers are aligned laterally.

The photoelectric conversion element having an adjacency structure in which a p-semiconductor layer, an intrinsic semiconductor layer, and an n-semiconductor layer are positioned adjacently to each other as above is a so-called pin photoelectric conversion element. The photoelectric conversion element having an adjacency structure in which an n-semiconductor layer, an intrinsic semiconductor layer, and an n-semiconductor layer are positioned adjacently to each other as above is a so-called nin photoelectric conversion element.

The pin or nin photoelectric conversion element is suitable for the application of a solar cell, an optical sensor etc. because the pin or nin photoelectric conversion element generates electrons and electron holes at the intrinsic semiconductor layer and can efficiently take out a current.

Furthermore, the vertical structure is advantageous for reducing the area occupied by the photoelectric conversion element. The lateral structure is advantageous for thinning the photoelectric conversion element. Besides, the lateral structure has a merit of higher sensing speed (optical response speed) than that of the vertical structure since the lateral structure has a less amount of overlapping layers than the vertical structure and consequently smaller parasitic capacitance between the layers.

The photoelectric conversion element of the present invention is arranged such that an outermost layer at a side of the photoelectric conversion element which side is opposite to a side where light is incident to the photoelectric conversion element is a metal layer covering a whole of the opposite side.

With the arrangement, the metal layer reflects light having been transmitted by the photoelectric conversion layer etc. so that the light travels to the photoelectric conversion layer again. This increases the photoelectric conversion ratio. Furthermore, the metal layer can serve as an electrode via which a current is taken out.

In the present invention, the photonic crystal is not necessarily required to be formed throughout the photoelectric conversion layer. Formation of the photonic crystal at a part of the photoelectric conversion layer allows increasing the photoelectric conversion ratio than a conventional technique. In this case, the metal layer is preferably provided at the whole of a lower region corresponding to the part where the photonic crystal is provided.

The present invention is not limited to the description of the embodiments above, but may be altered by a skilled person within the scope of the claims. An embodiment based on a proper combination of technical means disclosed in different embodiments is encompassed in the technical scope of the present invention.

Industrial Applicability

The present invention is applicable to various kinds of photoelectric conversion elements. In particular, the present invention is preferably applicable to photoelectric conversion elements such as solar cells and optical sensors.

Reference Signs List

| | |
|---|---|
| 1, 10, 11, 60 | Photoelectric conversion element |
| 2, 2a | Photoelectric conversion layer |
| 3, 72 | Transparent conductive layer (one of two layers) |
| 4, 74 | Transparent conductive layer (the other of two layers) |
| 6, 48 | Metal electrode layer (metal layer) |
| 20 | Intrinsic semiconductor layer |
| 20a | Intrinsic semiconductor layer |
| 20b | Intrinsic semiconductor layer |
| 21 | p-semiconductor layer |
| 21a | p-semiconductor layer |
| 22 | n-semiconductor layer |
| 22a | n-semiconductor layer |
| 22b | n-semiconductor layer |
| 30, | 30a, 30b, 76, 76a-76d Nanorods (columnar mediums) |
| 31, 31a, 31b, 77 | Defect |
| 40 | Passivation film (one of two layers) |
| 41, 47 | Insulating film (the other of two layers) |
| 42 | Reflective film (metal layer) |
| 78 | Defect region |
| c | Defect level |
| g | Photonic band gap |
| p | Pitch |
| x | Direction (specific direction) |

**Claims**

1. A photoelectric conversion element, comprising:

   a photoelectric conversion layer; and
   a photonic crystal provided inside the photoelectric conversion layer in such a manner as to have a photonic band gap, the photonic crystal being designed such that columnar mediums whose refraction index is smaller than that of a medium of the photoelectric conversion layer are provided periodically inside the medium of the photoelectric conversion layer, and there are provided defects where the columnar mediums are not provided in order to provide a defect level in the photonic band gap,

when a wavelength of a resonance peak corresponding to the defect level is $\lambda$, the columnar mediums are provided two-dimensionally with a pitch of not less than $\lambda/7$ and not more than $\lambda/2$ with respect to the wavelength $\lambda$, and

a relation $0.2\ Qv \leq Q_\alpha \leq 5.4\ Qv$ being met,

wherein Qv is a Q value representing a magnitude of a resonance effect yielded by coupling between the photonic crystal and an outside and is proportional to an inverse number of a coefficient $\kappa_v$ indicative of strength of coupling between the photonic crystal and the outside, and $Q_a$ is a Q value representing a magnitude of a resonance effect yielded by the medium of the photoelectric conversion layer and is proportional to an inverse number of a coefficient of absorption of light by the medium of the photoelectric conversion layer.

2. The photoelectric conversion element as set forth in claim 1, wherein the photonic crystal is designed such that the columnar mediums each have a height equal to a thickness of the photoelectric conversion layer.

3. The photoelectric conversion element as set forth in claim 1, wherein the photonic crystal is designed such that the columnar mediums each have a height smaller than a thickness of the photoelectric conversion layer.

4. The photoelectric conversion element as set forth in any one of claims 1 to 3, wherein
the columnar mediums are positioned at corners and a center of each of a plurality of hexagons consisting of triangular lattices on a plan view, and
when the plurality of hexagons are referred to as first units and the pitch for the columnar mediums is a,

   the first units are provided two-dimensionally with a pitch of 2a in an x-direction and √3a in a y-direction, and
   the defects are provided in a square lattice manner with a pitch of 4a to 8a in an x-direction and 2√3a to 4√3a in a y-direction.

5. The photoelectric conversion element as set forth in any one of claims 1 to 3, wherein
the columnar mediums are positioned at corners and a center of each of a plurality of hexagons consisting of triangular lattices and the defects are provided in the number of at least two in the plurality of hexagons on a plan view, and
when the hexagons having the at least two defects are referred to as second units and the pitch for the columnar mediums is a,

   the second units are provided two-dimensionally with a pitch of not less than 4a in an x-direction and √3a in a y-direction, and
   the defects are provided in a square lattice manner with a pitch of 4a to 8a in an x-direction and 2√3a to 4√3a in a y-direction.

6. The photoelectric conversion element as set forth in claim 4, wherein among the columnar mediums surrounding the defects, two columnar mediums positioned on a line extending in a specific direction are shifted oppositely to each other from the corners of the hexagon in the specific direction so that a distance between the two columnar mediums are shorter.

7. The photoelectric conversion element as set forth in any one of claims 1 to 6, wherein the photoelectric conversion layer is interleaved between two layers each consisting of a medium whose refraction index is smaller than that of the medium of the photoelectric conversion layer, and at least one of the two layers is transparent.

8. The photoelectric conversion element as set forth in any one of claims 1 to 7, wherein the photoelectric conversion layer has an adjacency structure in which a p-semiconductor layer, an intrinsic semiconductor layer, and an n-semiconductor layer are positioned adjacently to each other or an adjacency structure in which an n-semiconductor layer, an intrinsic semiconductor layer, and an n-semiconductor layer are positioned adjacently to each other, and the adjacency structure is a vertical structure in which individual layers are laminated vertically or a lateral structure in which individual layers are aligned laterally.

9. The photoelectric conversion element as set forth in any one of claims 1 to 8, wherein an outermost layer at a side of the photoelectric conversion element which side is opposite to a side where light is incident to the photoelectric conversion element is a metal layer covering a whole of the opposite side.

FIG. 1

(a)

(b)

(c)

F I G. 2

F I G. 3

LOW DIELECTRIC
BAND

HIGH DIELECTRIC
BAND

NORMALIZED FREQUENCY (p/λ)

0.4

0.3

0.2

0.1

Γ    K    M    Γ

ANGULAR ORIENTATION
IN WHICH LIGHT IS INCIDENT

F I G. 4

F I G. 5

F I G. 6

EASINESS $\kappa_v$ IN COUPLING WITH OUTSIDE
(EXPRESSED IN Q VALUE: $1/Q_v$)

ABSORPTION $\alpha$ BY PHOTOVOLTAIC MATERIAL
(EXPRESSED IN Q VALUE: $1/Q_\alpha$)

RATIO $\kappa_{in}$ OF PROPAGATION IN PLANE
(EXPRESSED IN Q VALUE: $1/Q_{in}$)

F I G. 7

COUPLING $\kappa_v$ WITH OUTSIDE SPACE
(EXPRESSED IN Q VALUE: $1/Q_v$)

RESONATOR

ABSORPTION $\alpha$ BY PHOTOVOLTAIC MATERIAL
(EXPRESSED IN Q VALUE: $1/Q_\alpha$)

F I G. 8

INTENSITY

$\Delta\lambda$

$\lambda_P$

WAVELENGTH

FIG. 9

F I G. 1 0

(a)

(b)

(c)

# FIG. 11

(a)

(b)

(c)

F I G. 1 2

60

a

r

76

71

72

73

74

75

F I G. 1 3

# F I G. 1 4

# F I G. 1 5

F I G.  1 6

F I G.　1 7

F I G.　1 8

FIG. 19

(a)

350nm SiO₂ — 81
— 72
— 71

↑ DIRECTION IN
WHICH LIGHT
IS INCIDENT

(b)

900nm — 82
350nm SiO₂ — 81
— 72
— 71

(c)

300nm — 83
900nm — 82
350nm SiO₂ — 81
— 72
— 71

(d)

300nm — 83
350nm SiO₂ — 81
— 72
— 71

(e)

90

300nm — 83
350nm SiO₂ — 76
— 72
— 71

(f)

ETCHING OF Al BY HCl
— 76
330nm SiO₂ — 86
— 85
— 84
— 72
— 71

(g)

1
— 88
— 87
— 86
76 — — 85
SiO₂ — 84
— 72
— 71

↑ DIRECTION IN
WHICH LIGHT
IS INCIDENT

F I G. 2 0

ABSORPTION RATIO OF a-Si
(BASED ON MEASUREMENT: 330 nm IN THICKNESS)

ABSORPTION EDGE

TRANSMITTANCE
(BASED ON MEASUREMENT)

1.2
1.0
0.8
0.6
0.4
0.2
0.0

300    400    500    600    700    800    900    1000

WAVELENGTH (nm)

F I G. 2 1

## INTERNATIONAL SEARCH REPORT

| International application No. |
|---|
| PCT/JP2010/073214 |

**A. CLASSIFICATION OF SUBJECT MATTER**
*H01L31/04*(2006.01)i

According to International Patent Classification (IPC) or to both national classification and IPC

**B. FIELDS SEARCHED**

Minimum documentation searched (classification system followed by classification symbols)
H01L31/04-31/078

Documentation searched other than minimum documentation to the extent that such documents are included in the fields searched

| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
JSTPlus(JDreamII), JST7580(JDreamII)

**C. DOCUMENTS CONSIDERED TO BE RELEVANT**

| Category* | Citation of document, with indication, where appropriate, of the relevant passages | Relevant to claim No. |
|---|---|---|
| A | O. El Daif et al., Photonic band-engineering absorption enhancement of amorphous silicon for solar cells, PROC. OF SPIE, 2009.08.20, Vol. 7411, pp. 74110O-1-8 | 1-9 |
| A | A. Chutinan et al., Light trapping and absorption in certain thin-film photonic crystal architectures, PHYSICAL REVIEW A, 2008.08.14, Vol. 78, pp. 023825-1-15 | 1-9 |
| A | D. Zhou et al., Photonic crystal enhanced light-trapping in thin film solar cells, JOURNAL OF APPLIED PHYSICS, 2008.05.01, Vol.103, pp. 093102-1-5 | 1-9 |

☒ Further documents are listed in the continuation of Box C.    ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 28 March, 2011 (28.03.11) | 05 April, 2011 (05.04.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

### INTERNATIONAL SEARCH REPORT

| International application No. |
| --- |
| PCT/JP2010/073214 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2009-533875 A  (Massachusetts Institute of Technology), 17 September 2009 (17.09.2009), paragraphs [0010] to [0023]; fig. 2 to 4 & US 2007/0235072 A1    & EP 2018668 A & WO 2007/121082 A2 | 1-9 |
| A | JP 2008-124230 A  (Kaneka Corp.), 29 May 2008 (29.05.2008), claims 1 to 5; paragraphs [0018] to [0057]; fig. 1 to 2 (Family: none) | 1-9 |
| P,A | Hiroaki SHIGETA et al., "Koki Denryoku Soshi no Koden Henkan Koritsu Zodai ni Muketa Photonic Kessho Kyoshin Sayo no Saiteika", Dai 57 Kai Extended Abstracts, Japan Society of Applied Physics and Related Societies, 03 March 2010 (03.03.2010), lecture no. 19p-M-14 | 1-9 |
| P,A | G. Gomard et al., Two-dimensional photonic crystal for absorption enhancement in hydrogenated amorphous silicon thin film solar cells, JOURNAL OF APPLIED PHYSICS, 2010.12.16, Vol.108, pp. 123102-1-8 | 1-9 |
| P,A | P. A. Postigo et al., Enhancement of solar cell efficiency using two-dimensional photonic crystals, PROC. OF SPIE, 2010.05.11, Vol. 7713, pp. 771307-1-7 | 1-9 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009533875 PCT
- JP 2006024495 A
- JP 2006032787 A
- WO 2007108212 A

**Non-patent literature cited in the description**

- **C.MANOLATOU ; M.J.KHAN ; SHANHUI FAN ; PIERRE R.VILLENEUVE ; H.A.HAUS ; J.D.JOAN-NOPOULOS.** Coupling of Modes Analysis of Resonant Channel Add-Drop Filters. *IEEE JOUNAL OF QUANTUM ELECTRONICS,* September 1999, vol. 35, 1322-1331
- **J.R.TUMBLESTON ; DOO-HYUN KO ; EDWARD T.SAMULSKI ; RENE LOPEZ.** Absorption and quasiguided mode analysis of organic solar cells with photonic crystal photoactive layers. *OPTICS EXPRESS/Optical Society of America,* 27 April 2009, vol. 17 (9), 7670-7681